# EUROPEAN PATENT SPECIFICATION

(11) **EP 0 537 085 B1**
(45) Date of publication and mention of the grant of the patent: **08.11.1995**
(21) Application number: 92420324.3
(22) Date of filing: 22.09.1992
(51) Int. Cl.: G07F 7/10, H05K 7/14

(54) **Device for indicating the presence of an optional component on a board**
Erkennungsvorrichtung für das Vorhandensein wählbarer Komponenten auf einer Karte
Dispositif d'indication de la présence d'un composant optionnel sur une carte

(30) Priority: 26.09.1991 FR 9112142
(43) Date of publication of application: 14.04.1993
(73) Proprietor: Hewlett-Packard Company, Palo Alto, California 94304 (US)
(72) Inventor: Sauvage, Pierre, F-38560 Champ sur Drac (FR)
(74) Representative: Squibbs, Robert Francis

(56) References cited:
- EP-A- 0 123 595
- EP-A- 0 289 157
- DE-A- 3 504 560

## Description

The present invention relates to microprocessor boards, and in particular to a device for indicating the presence of an optional component which can be added to the board.

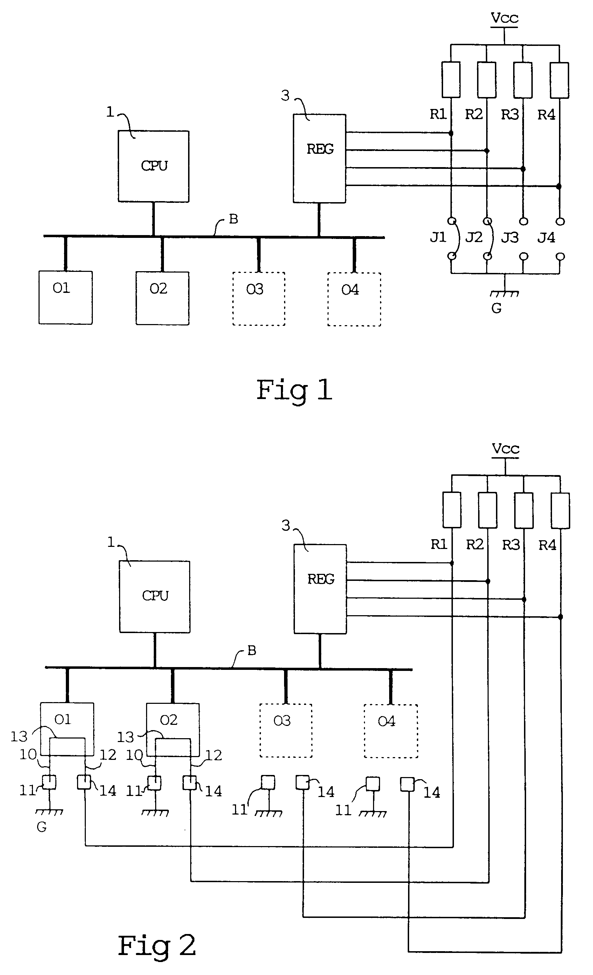

Figure 1 represents a partial simplified diagram of a conventional microprocessor board. This board comprises a microprocessor 1 connected to a system bus B, various specific components (not represented) of the board, and optional components, for example four O1 to O4, meant to be connected to bus B. These components can be integrated circuits or boards that can be plugged into connectors of the microprocessor board. In the shown example, the components O3 and O4 are absent, which is indicated by dashed lines.

To each optional component are associated a resistor R1 to R4 and a switch J1 to J4. The resistors and the switches are connected in series respectively between a power supply terminal VCC and ground G. Each junction between a resistor and a switch is connected to the input of a register 3, itself connected to bus B. Thus, by closing or opening the switches J, the logic states of the corresponding bits of the register are modified. The microprocessor, at power-on, reads the states of the bits of the register and will detect which optional component is present.

In order to indicate that components O1 and O2 are present, switches J1 and J2 are closed and the (corresponding bits are at a first state 0. In order to indicate that the components O3 and O4 are absent, the switches J3 and J4 are open and the corresponding bits of the register are at a second state 1.

In fact, switches J1 to J4 are in the form of jumpers on the board which must be inserted or removed by an operator as a function of the optional components he adds or removes.

A drawback of this device is that an operator, who adds or removes an optional component and acts upon the corresponding jumper, can act upon a mistaken jumper because, generally, the reference numeral of the jumper marked on the board is little visible and/or the jumpers are placed very near to each other and are rather inaccessible. The operator can also simply forget to change a jumper setting because he does not know that this must be done. Moreover, these settings are tedious because, when an optional component is added or removed, the operator must consult a technical manual to know which jumper setting he must change.

### SUMMARY OF THE INVENTION

An object of the invention is to provide an arrangement for automatically indicating the presence of optional components.

Another object of the invention is to provide an arrangement for indicating the presence of optional components not needing a jumper setting.

Another object of the invention is to provide an arrangement for indicating the presence of optional components occupying a reduced surface on the board.

According to the present invention, there is provided, in combination, a microprocessor board having a plurality of connection means for receiving respective optional electronic components, and at least one such optional electronic component; said at least one optional electronic component having a plurality of electrical contact pins including a first and a second said pin, and means electrically interconnecting said first and second pins; each said connection means of the microprocessor board having a plurality of contacts including a first and a second contact for respectively making electrical contact with said first and second pins of said at least one optional component upon the latter being inserted into said connection means; said microprocessor board further having:
- a first voltage supply line,
- a second voltage supply line connected to the said first contact of each said connection means,
- respective biased logic-level means associated with each said connection means, each said biased logic-level means having a logic-level reference point and being connected to said first supply line to establish a first voltage logic level at said reference point in the absence of a said optional electronic component in the corresponding said connection means, the said biased logic-level means being further connected to the said second contact of the corresponding said connection means and being responsive to said second contact being connected to said second voltage supply line, through the said second and first pins of a said optional electronic component inserted in the connection means, to cause a second voltage logic level to be established at said reference point replacing the said first logic level, and
- analyzing means connected to the said reference point of each said connection means for determining the logic level thereat thereby to determine whether a said optional electronic component has been inserted in the corresponding connections means.

Preferably, the biased logic-level means comprises a respective resistor connected between each said second contact and said first voltage supply line and the analysing means comprises a register for storing the logic state present at the reference point of each said biased logic-level means.

### BRIEF DESCRIPTION OF THE DRAWINGS

The foregoing and other objects, features and advantages of the invention are exposed in more detail in the following description of preferred embodiments and by referring to the attached drawings among which:
figure 1, previously discribed, shows a conventional device for indicating the presence of optional components; and
figure 2 shows an embodiment of a device for indicating the presence of optional components according to the invention.

### DESCRIPTION OF PREFERRED EMBODIMENTS

In figure 2 are shown some of the elements of figure 1 designated by same reference numerals. In general, the optional components (integrated circuits or boards) O1, O2... comprise at least one supply pin (or contact) 10 which must be connected on the microprocessor board to a constant voltage, for example to ground G. To this supply pin 10 is associated a contact 11 of the board.

According to the invention, in each optional component there is provided a specific pin 12 which is connected by a connection 13 internal to the component to the supply pin 10. The board comprises contacts 14 corresponding to each of the specific pins 12. The terminals of the resistors R connected to register 3, instead of being connected to jumpers, are each connected to a contact 14. The specific pin 12, in order to avoid adding an extra pin to the cases of the optional components, is an unused pin, often available, of a conventional component.

As shown, component O1 and O2 are present and components O3 and O4 absent. For a present optional component O, the corresponding contacts 11 and 14 are shortcircuited by the internal connection 13, which has the same effect as closing the associated switch J of figure 1. For an absent component O, the corresponding contacts 11 and 14 are not connected to each other, which has the same effect as opening an associated switch J of figure 1.

Thanks to the present invention, the simple insertion of an optional component indicates to the system its presence by setting the corresponding bit in register 3 as the setting of a jumper would have done conventionally. The invention thus ensures an automatic indication of the presence of optional components.

Moreover, the suppression of jumpers results in a substantial surface gain on the board. Of course, the connections (copper tracks) between the resistors and contacts 14 must be added to the board, but their surface occupation is reduced because these connections can be very thin as the currentscirculating therein are very low.

Many modifications and alternatives of the invention will appear to those skilled in the art.Especially, the mentioned supply pins can be connected to a high voltage, resistors R then being connected to a low voltage, such as ground. The internal connections 13 between the supply pin and the specific pin of a component can be resistive.

## Claims

1. In combination, a microprocessor board having a plurality of connection means for receiving respective optional electronic components (O1 - O4), and at least one such optional electronic component (O1, O2); said at least one optional electronic component (O1, O2) having a plurality of electrical contact pins including a first and a second said pin (10, 12), and means (13) electrically interconnecting said first and second pins (10, 12); each said connection means of the microprocessor board having a plurality of contacts including a first and a second contact (11, 14) for respectively making electrical contact with said first and second pins (10, 12) of said at least one optional component (O1, O2) upon the latter being inserted into said connection means; said microprocessor board further having:
- a first voltage supply line (Vcc),
- a second voltage supply line (G) connected to the said first contact (11) of each said connection means,
- respective biased logic-level means (R1 - R4) associated with each said connection means, each said biased logic-level means (R1 - R4) having a logic-level reference point and being connected to said first supply line (Vcc) to establish a first voltage logic level at said reference point in the absence of a said optional electronic component (O1 - O4) in the corresponding said connection means, the said biased logic-level means (R1 - R4) being further connected to the said second contact (14) of the corresponding said connection means and being responsive to said second contact (14) being connected to said second voltage supply line (G), through the said second and first pins (12, 10) of a said optional electronic component inserted in the connection means, to cause a second voltage logic level to be established at said reference point replacing the said first logic level, and
- analyzing means (3) connected to the said reference point of each said connection means for determining the logic level thereat thereby to determine whether a said optional electronic component (O1 - O4) has been inserted in the corresponding connections means.

2. The combination of claim 1, wherein the biased logic-level means comprises a respective resistor (R1 - R4) connected between each said second contact (14) and said first voltage supply line (Vcc).

3. The combination of claim 1, wherein the analysing means comprises a register (3) for storing the logic state present at the reference point of each said biased logic-level means (R1 - R4).

4. The combination of claim 1, wherein said at least one optional electronic component (O1, O2) is an integrated circuit.

5. The combination of claim 1, wherein the said means (13) electrically interconnecting said first and second pins (10, 12) is a resistor.

## Patentansprüche

1. Eine Kombination einer Mikroprozessorplatine und einer Mehrzahl von Verbindungseinrichtungen zum Aufnehmen jeweiliger optionaler elektronischer Komponenten (O1 - O4) und zumindest einer solchen optionalen elektronischen Komponente (O1, O2); wobei die zumindest eine optionale elektronische Komponente (O1, O2) eine Mehrzahl von elektrischen Anschlußstiften, die einen ersten und einen zweiten Anschlußstift (10, 12) aufweisen, und eine Einrichtung (13), die den ersten und den zweiten Anschlußstift (10, 12) elektrisch verbindet, aufweist; wobei die Verbindungseinrichtung der Mikroprozessorplatine eine Mehrzahl von Kontakten aufweist, die einen ersten und einen zweiten Kontakt (11, 14) einschließen, um jeweils einen elektrischen Kontakt mit dem ersten und dem zweiten Anschlußstift (10, 12) der zumindest einen optionalen Komponente (O1, O2) herzustellen, wenn die letztgenannte in die Verbindungseinrichtung eingefügt ist; wobei die Mikroprozessorplatine ferner folgende Merkmale aufweist:
- eine erste Spannungsversorgungsleitung (Vcc),
- eine zweite Spannungsversorgungsleitung (G), die mit dem ersten Kontakt (11) jeder Verbindungseinrichtung verbunden ist,
- jeweilige vorgespannte Logikpegeleinrichtungen (R1 - R4), die jeder Verbindungseinrichtung zugeordnet sind, wobei jede vorgespannte Logikpegeleinrichtung (R1 - R4) einen Logikpegel-Referenzpunkt aufweist und mit der ersten Versorgungsleitung (Vcc) verbunden ist, um bei einer Nicht-Präsenz der optionalen elektronischen Komponente (O1 - O4) in der entsprechenden Verbindungseinrichtung einen ersten logischen Spannungspegel an dem Referenzpunkt einzurichten, wobei die vorgespannte Logikpegeleinrichtung (R1 - R4) ferner mit dem zweiten Kontakt (14) der entsprechenden Verbindungseinrichtung verbunden ist und durch den zweiten und den ersten Anschlußstift (12, 10) der optionalen elektronischen Komponente, die in die Verbindungseinrichtung eingefügt ist, darauf anspricht, daß der zweite Kontakt (14) mit der zweiten Spannungsversorgungsleitung (G) verbunden ist, um zu bewirken, daß ein zweiter logischer Spannungspegel an dem Referenzpunkt eingerichtet wird, der den ersten logischen Pegel ersetzt, und
- eine Analysiereinrichtung (3), die mit dem Referenzpunkt jeder Verbindungseinrichtung verbunden ist, um den logischen Pegel an demselben zu bestimmen, um dadurch zu bestimmen, ob die optionale elektronische Komponente (O1 - O4) in die entsprechende Verbindungseinrichtung eingefügt wurde.

2. Die Kombination gemäß Anspruch 1, bei der die vorgespannte Logikpegeleinrichtung jeweils einen Widerstand (R1 - R4) aufweist, der zwischen jeden zweiten Kontakt (14) und die erste Spannungsversorgungsleitung (Vcc) geschaltet ist.

3. Die Kombination gemäß Anspruch 1, bei der die Analysiereinrichtung ein Register (3) aufweist, um den logischen Zustand zu speichern, der an dem Referenzpunkt jeder vorgespannten Logikpegeleinrichtung (R1 - R4) vorliegt.

4. Die Kombination gemäß Anspruch 1, bei der die zumindest eine optionale elektronische Komponente (O1, O2) eine integrierte Schaltung ist.

5. Die Kombination gemäß Anspruch 1, bei der die Einrichtung (13), die den ersten und den zweiten Anschlußstift (10, 12) verbindet, ein Widerstand ist.

## Revendications

1. En combinaison, une carte à microprocesseur ayant une pluralité de moyens de connexion pour recevoir des composants électroniques optionnels (O1-O4), et au moins un tel composant électronique optionnel (O1, O2) ; ledit au moins un composant électronique optionnel (O1, O2) ayant une pluralité de broches de contact électrique comprenant une première et une deuxième dite broche (10, 12), et des moyens (13) connectant électriquement lesdites première et deuxième broches (10, 12) l'une à l'autre ; chacun desdits moyens de connexion de la carte à microprocesseur ayant une pluralité de contacts comprenant un premier et un deuxième contact (11, 14) pour réaliser respectivement un contact électrique avec lesdites première et deuxième broches (10, 12) dudit au moins un composant optionnel (O1, O2) tandis que celui-ci est inséré dans ledit moyen de connexion ; ladite carte à microprocesseur comprenant en outre :
- une première ligne d'alimentation électrique (Vcc),
- une deuxième ligne d'alimentation électrique (G) connectée au premier contact (11) de chacun desdits moyens de connexion,
- des moyens polarisés respectifs de niveau logique (R1-R4) associés à chacun desdits moyens de connexion, chacun desdits moyens polarisés de niveau logique (R1-R4) ayant un point de référence de niveau logique et étant connecté à ladite première ligne d'alimentation (VCC) pour établir un premier niveau logique de tension audit point de référence en l'absence dudit composant électronique optionnel (O1-O4) dans ledit moyen de connexion correspondant, ledit moyen polarisé de niveau logique (R1-R4) étant en outre connecté audit deuxième contact (14) dudit moyen de connexion correspondant et agissant en réponse audit deuxième contact (14) lorsque celui-ci est connecté à ladite deuxième ligne d'alimentation (G), par l'intermédiaire desdites première et deuxième broches (12, 10) dudit composant électronique optionnel inséré dans le moyen de connexion, pour provoquer l'établissement d'un deuxième niveau logique de tension audit point de référence remplaçant ledit premier niveau logique, et
- des moyens d'analyse (3) connectés audit point de référence de chacun desdits moyens de connexion pour déterminer le niveau logique et par conséquent déterminer si un desdits composants électroniques optionnels (O1-O4) a été inséré dans le moyen de connexion correspondant.

2. La combinaison de la revendication 1, dans laquelle le moyen polarisé de niveau logique comprend une résistance respective (R1-R4) connectée entre chacun dudit deuxième contact (14) et de ladite première tension d'alimentation (VCC).

3. La combinaison de la revendication 1, dans laquelle le moyen d'analyse comprend un registre (3) pour stocker l'état logique présent au point de référence de chacun des moyens polarisés de niveau logique (R1-R4).

4. La combinaison de la revendication 1, dans laquelle ledit au moins un composant électronique optionnel (O1, O2) est un circuit intégré.

5. La combinaison de la revendication 1, dans laquelle ledit moyen (13) connectant électriquement lesdites première et deuxième broches (10, 12) entre elles est une résistance.
